# EUROPEAN PATENT APPLICATION

(11) **EP 3 913 910 A1**
(43) Date of publication of application: **24.11.2021**
(21) Application number: 20217076.7
(22) Date of filing: 23.12.2020
(51) Int. Cl.: H04N 5/64, G06F 1/16

(54) **INTEGRATED MODULE AND DISPLAY EQUIPMENT**

(30) Priority: 18.05.2020 CN 202010419239
(71) Applicant: Beijing Xiaomi Mobile Software Co., Ltd., Beijing 100085 (CN)
(72) Inventor: ZHOU, Yihui, Beijing, 100085 (CN); LI, Xuan, Beijing, 100085 (CN); LU, Shihwei, Beijing, 100085 (CN)
(74) Representative: Hughes, Andrea Michelle

(57) **Abstract**

An integrated module (100, 702, 802) includes a module housing (101), an audio input component (102), and an integrated component (103). The module housing (101) has a transmission hole. The audio input component (102) is located inside the module housing (101). The integrated component (103) is located inside the module housing (101). The integrated component (103) includes multiple functional devices of different types. The transmission hole is provided for a transmission line that establishes an electrical connection with at least one of the audio input component (102) or the integrated component (103) to pass through.

## Description

### TECHNICAL FIELD

The subject disclosure relates to the field of television, and more particularly, to an integrated module and display equipment.

### BACKGROUND

With development of high technology, an increasing number of smart products enter household life. These smart products are having increasingly rich functions as they meet an increasing number of user demands. Due to the abundance of functions, a smart product may include an increasing number of functional devices. Space for laying out various functional devices has to be provided. When these functional devices are scattered at various locations in the smart product, for example, some on the back of the smart product and others below the smart product, more space is required for placing the devices, with messy distribution. In addition, as functional devices of different smart products are mostly in different locations, maintenance becomes cumbersome in case of a fault.

### SUMMARY

Embodiments herein provide an integrated module and display equipment.

According to a first aspect herein, an integrated module includes a module housing, an audio input component, and an integrated component.

The module housing has a transmission hole.

The audio input component is located inside the module housing.

The integrated component is located inside the module housing. The integrated component includes multiple functional devices of different types.

The transmission hole is provided for a transmission line, that establishes an electrical connection with at least one of the audio input component or the integrated component, to pass through.

With embodiments herein, an audio input component and an integrated component including multiple functional devices of different types are provided in a same module housing, forming an integrated module. In this way, by integrating, in one module housing, respective functional devices that would have been scattered here and there, space occupied by layout of the functional devices may be reduced. In addition, integrating respective functional devices in one module housing facilitates subsequent maintenance. That is, when a functional device in the integrated module fails, only the integrated module has to be detached and maintained separately, instead of moving the entire device for maintenance, which also facilitates maintenance, as well as saving time spent by maintenance personnel looking for a mounting location of a functional device in different products or for different models.

The transmission hole may be located on a first housing of the module housing.

The audio input component may be mounted on a first circuit board and may face a second housing of the module housing. The second housing may be adjacent to the first housing.

The integrated component may be mounted on a second circuit board and may face a third housing of the module housing. The third housing may be adjacent to the second housing.

The second housing may be provided with an opening for outputting light.

The first circuit board may be provided with at least one notch. The at least one notch may face the opening.

The multiple functional devices may include a breathing light. There may be a light guide device between the breathing light and the notch.

A length of the notch on the first circuit board may be same as a length of a line of a plurality of breathing lights on the second circuit board.

The second circuit board may be parallel to the third housing and may include a first outer surface facing the third housing. The first outer surface may be provided with at least one mounting location.

The breathing light may be located at the at least one mounting location, with a light-emitting surface facing the second housing.

The second circuit board may further include a second outer surface facing the first housing. The second outer surface may be opposite to the first outer surface.

The multiple functional devices may include a connector.

The connector may be located on the second outer surface. The connector may be connected to the transmission line passing through the transmission hole. The connector may be configured to provide an electric connection for the second circuit board.

The multiple functional devices may include an infrared collector.

A collecting surface of the infrared collector may face the second housing. The second housing may be made of material that allows infrared light to pass through.

The first circuit board may be adhered to the second housing. The second housing may have a sound hole.

The audio input component may include a pickup. The pickup may be aligned with the sound hole.

The first circuit board may include a side surface. The side surface may be perpendicular to a surface adhesively connected to the second housing, and may face the first housing.

A light-shielding plate may be provided on an inner side of the first housing. The light-shielding plate may cover the side surface of the first circuit board. An area of the light-shielding plate may be no less than an area of the side surface.

The multiple functional devices may include a button.

The button may be located on the second circuit board. A control surface of the button may face the third housing.

According to a second aspect herein, display equipment includes a main body and an integrated module herein.

The main body includes a display.

The integrated module is detachably connected to the main body.

The advantages and technical effects of the display equipment herein correspond to those of the integrated module presented above.

The main body may further include a motherboard.

Both the motherboard and the display may be located inside an equipment housing.

The equipment housing may be provided with a through hole.

The transmission line of the integrated module may be connected to the motherboard through the through hole.

The above general description and detailed description below are but exemplary and explanatory, and do not limit the subject disclosure.

### BRIEF DESCRIPTION OF THE ACCOMPANYING DRAWINGS

Drawings here are incorporated in and constitute part of the subject disclosure, illustrate embodiments according to the subject disclosure, and together with the subject disclosure, serve to explain the principle of the subject disclosure.
FIG. 1 is an unfolded view of a structure of an integrated module according to an exemplary embodiment.
FIG. 2 is a diagram of a module housing in an integrated module according to an exemplary embodiment.
FIG. 3 is a diagram of structures of a first circuit board and a second circuit board in an integrated module according to an exemplary embodiment.
FIG. 4 is a diagram of structures of a first circuit board and a second circuit board in an integrated module according to an exemplary embodiment.
FIG. 5 is an unfolded view of a structure of an integrated module according to an exemplary embodiment.
FIG. 6 is a diagram of locations of an infrared collector, breathing lights, a button, and a connector located on a second circuit board in an integrated module according to an exemplary embodiment.
FIG. 7 is a diagram of a structure of display equipment according to an exemplary embodiment.
FIG. 8 is a diagram of a physical entity of a TV according to an exemplary embodiment.
FIG. 9 is a diagram of a control circuit of an integrated module in display equipment according to an exemplary embodiment.
FIG. 10 is a diagram of a control circuit of breathing lights in display equipment according to an exemplary embodiment.
FIG. 11 is a block diagram of electronic equipment including an integrated module according to an exemplary embodiment.

### DETAILED DESCRIPTION

Exemplary embodiments (examples of which are illustrated in the accompanying drawings) are elaborated below. The following description may refer to the accompanying drawings, in which identical or similar elements in two drawings are denoted by identical reference numerals unless indicated otherwise. Implementations set forth in the following exemplary embodiments do not represent all implementations in accordance with the subject disclosure. Rather, they are mere examples of the apparatus (i.e., device / equipment / terminal) and or method in accordance with certain aspects of the subject disclosure as recited in the accompanying claims. The exemplary implementation modes may take on multiple forms, and should not be taken as being limited to examples illustrated herein. Instead, by providing such implementation modes, embodiments herein may become more comprehensive and complete, and comprehensive concept of the exemplary implementation modes may be delivered to those skilled in the art. Implementations set forth in the following exemplary embodiments do not represent all implementations in accordance with the subject disclosure. Rather, they are merely examples of the apparatus and method in accordance with certain aspects herein as recited in the accompanying claims.

Note that although a term such as first, second, third may be adopted in an embodiment herein to describe various kinds of information, such information should not be limited to such a term. Such a term is merely for distinguishing information of the same type. For example, without departing from the scope of the embodiments herein, the first information may also be referred to as the second information. Similarly, the second information may also be referred to as the first information. Depending on the context, a "if" as used herein may be interpreted as "when" or "while" or "in response to determining that".

In addition, described characteristics, structures or features may be combined in one or more implementation modes in any proper manner. In the following descriptions, many details are provided to allow a full understanding of embodiments herein. However, those skilled in the art will know that the technical solutions of embodiments herein may be carried out without one or more of the details; alternatively, another method, component, device, option, etc., may be adopted. Under other conditions, no detail of a known structure, method, device, implementation, material or operation may be shown or described to avoid obscuring aspects of embodiments herein.

A block diagram shown in the accompanying drawings may be a functional entity which may not necessarily correspond to a physically or logically independent entity. Such a functional entity may be implemented in form of software, in one or more hardware modules or integrated circuits, or in different networks and /or processor devices and /or microcontroller devices.

A terminal may sometimes be referred to as a smart terminal. The terminal may be a mobile terminal. The terminal may also be referred to as User Equipment (UE), a Mobile Station (MS), etc. A terminal may be equipment or a chip provided therein that provides a user with a voice and / or data connection, such as handheld equipment, onboard equipment, etc., with a wireless connection function. Examples of a terminal may include a mobile phone, a tablet computer, a notebook computer, a palm computer, a Mobile Internet Device (MID), wearable equipment, Virtual Reality (VR) equipment, Augmented Reality (AR) equipment, a wireless terminal in industrial control, a wireless terminal in unmanned drive, a wireless terminal in remote surgery, a wireless terminal in a smart grid, a wireless terminal in transportation safety, a wireless terminal in smart city, a wireless terminal in smart home, etc.

An indicator light, an infrared head, a button, a voice collector, etc., may be placed separately on an area such as an underside, a back side, etc., of a smart product such as a TV, a computer, etc., as a part or an individual component. Consequently, since there are a large number of parts scattered on the smart product, too much space may be required to place the respective parts. Moreover, excessive material may lead to cumbersome after-sales maintenance.

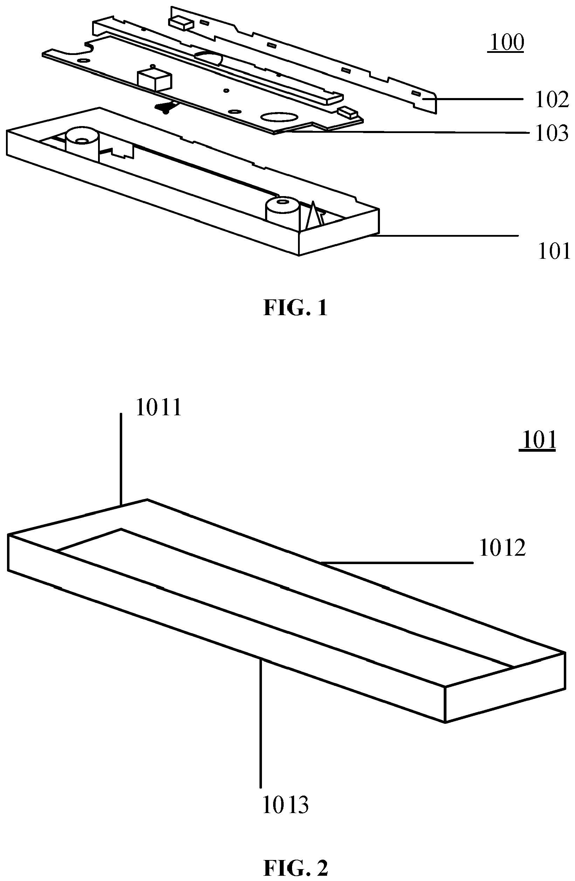

An integrated module save space occupied by various functional devices on a smart product. FIG. 1 is an unfolded view of a structure of an integrated module according to an exemplary embodiment. As shown in FIG. 1, the integrated module 100 includes a module housing, an audio input component, and an integrated component.

The module housing 101 has a transmission hole.

The audio input component 102 is located inside the module housing.

The integrated component 103 is located inside the module housing. The integrated component includes multiple functional devices of different types.

The transmission hole is provided for a transmission line to pass through. The transmission line is for establishing an electrical connection with the audio input component and / or the integrated component.

Note that an integrated module herein may be applied to any electronic equipment, including a TV, a computer, a printer, a smart phone, etc. Multiple functional devices or components on electronic equipment may be integrated inside a housing, forming an integrated module, thereby improving visual effect and reducing space occupied.

A module housing may serve to accommodate various components or various functional devices. A module housing may be designed to have a regular shape or a nearly regular shape, such as a cuboid or an approximate cuboid. A module housing may be designed to have any other shape, which is not limited herein. However, note that to facilitate layout and mounting, the module housing may be designed to have a cuboid or an approximate cuboid, such as a cuboid 145 mm long, 32.3 mm wide, and 13.7 mm high.

Here, a module housing may be movably connected to electronic equipment. That is, the module housing may be separated from the electronic equipment. Thus, a module housing may be connected to electronic equipment such as by screw, snap, etc. A movable connection may facilitate subsequent maintenance and management.

In addition, for ease of installation and portability, a module housing may be made of light-weight wear-resistant material such as plastic, metal, etc.

Note that if the module housing includes a light emitting device, and light emitted by the light emitting device has to be transmitted to the outside, the module housing may be made of transparent material that allows light to pass through. Alternatively, light output may be implemented by providing an opening on the module housing. For a functional device requiring light of a specific wave band, the module housing may be made of material that allows light of the specific wave band to pass through, such as material that allows infrared light or ultraviolet light to pass through.

A transmission hole on the module housing may serve to allow a functional device or component placed in the module housing to establish an electrical connection with a main body of electronic equipment through the transmission line, thereby implementing control of the functional device or component placed in the module housing. Here a main body of electronic equipment may refer to a motherboard in the electronic equipment for mounting various main chips.

Given that most existing functional devices or components do not have a wireless transmission function, and that wired transmission is fast and stable, herein, a functional device or component placed in a module housing may be connected to a main body of electronic equipment using a wire. However, in practical application, the connection may be wireless, which is not limited herein.

Here, the transmission hole may serve for a transmission line from any functional device or component in the module housing needing an electrical connection to pass through. In addition, given that a functional device or component may be laid out in the module housing along different orientations, different transmission holes may be provided for transmission lines from functional devices or components spaced apart to pass through.

The transmission hole may be provided along a direction in which the module housing establishes a connection with the electronic equipment. That is, the transmission hole may be provided at a location on the module housing that is adjacent to the electronic equipment. For example, when the module housing is provided below the electronic equipment, for ease of wiring, the transmission hole may be provided atop the module housing. When the module housing is provided to the left of the electronic equipment, the transmission hole may be provided on the right side of the module housing.

The transmission hole may be the entire surface where the module housing establishes a connection with the electronic equipment. That is, no housing is provided for the surface where the module housing establishes a connection with the electronic equipment, leaving the surface completely open. A transmission line from a functional device or component may pass directly through the open surface of the module housing, and then be connected to the main body of the electronic equipment.

The transmission hole may include a movable gate structure. In this way, after the integrated module is assembled, the transmission hole may be closed by closing the movable gate, protecting an internal structure of the integrated module.

The audio input component may refer to a component that collects an audio signal, such as a microphone, a pickup, etc. When being placed in the module housing, the audio input component may be connected to the main body of the electronic equipment through a transmission line passing through the transmission hole. With an audio signal collected by the audio input component, a user may be allowed to control the electronic equipment through voice. Correspondingly, a program for recognizing an audio signal may be stored in a voice recognition chip on the electronic equipment, implementing voice recognition, and sending a control instruction corresponding to a recognition result.

Here, herein, a plurality of pickups may be provided in the audio input component along a line, with fixed spacing in between, for collecting audio signals. The fixed spacing may be set according to the size of the integrated module. For example, when the length of the integrated module is 100 cm, the fixed spacing may be set to be within a range of 10 mm to 120 mm. The spacing may be set to reduce crosstalk of sound. The size of the spacing may be determined jointly according to a rule of thumb, or a rule of thumb and a layout requirement. The number of pickups may be determined as needed.

The number of pickups may be determined combining the size of the electronic equipment, the voice recognition effect, and the computing power of a processor. The more pickups, the more resources of the processor are consumed. While a fair voice recognition effect is achieved, fewer pickups may be selected to save the computing power of the processor. Based on a comprehensive consideration, the number of pickups may be 4, as determined according to a comprehensive consideration of a rate of occupation of resources of the processor as well as a recognition rate acquired by an actual measurement of the voice effect, which is not limited herein.

A dust screen may be provided on a pickup hole of a pickup. Accuracy in collecting an audio signal may be improved by reducing dust entering a pickup, thereby increasing the service life of the pickup.

A sound hole may be provided on a surface of the module housing facing a pickup in the audio input component, for collecting a clearer audio signal through the sound hole, maximizing accuracy in audio signal collection.

An integrated component may refer to a component formed by integrating multiple functional devices of different types on one circuit board.

The functional devices may include a light, a button, and various sensors or connectors. When being placed in the module housing, the integrated component may be connected to the main body of the electronic equipment through the transmission line passing through the transmission hole. That is, the circuit board on which the multiple functional devices of different types are located may be connected electrically to the motherboard in the electronic equipment. In this way, various applications may be implemented through information interaction between the functional devices in the integrated component and a main chip.

To collect an accurate audio signal, a great number of pickups or microphones may be provided in the audio input component. Accordingly, herein, the audio input component and other functional devices of different types may be provided separately, avoiding a bulk circuit board caused by providing all functional devices on the same circuit board.

Another functional device, such as an audio output component, an image collecting component, etc., may be provided in the module housing, which is not enumerated and elaborated herein.

Therefore, herein, an audio input component and an integrated component including multiple functional devices of different types are provided in a same module housing, forming an integrated module. In this way, by integrating, in one module housing, respective functional devices that would have been scattered here and there, space occupied by layout of the functional devices may be reduced. In addition, various functional devices are allowed to be managed in a standardized mode, facilitating subsequent maintenance, saving time spent by maintenance personnel looking for a mounting location of a functional device in different products or for different models.

The transmission hole may be located on a first housing of the module housing.

As mentioned above, the first housing may refer to the surface where the module housing establishes a connection with the electronic equipment, i.e., the surface closest to the main body of the electronic equipment. When the module housing is a cuboid provided under the main body of the electronic equipment, the first housing may be a top surface of the cuboid module housing.

FIG. 2 is a diagram of a module housing in an integrated module according to an exemplary embodiment. As shown in FIG. 2, when the transmission hole is provided on the first housing 1011, and the first housing 1011 is the surface where the top of the cuboid module housing 101 is located, a housing in the cuboid module housing 101 adjacent to the first housing 1011 may be the second housing 1012. The third housing 1013 may be another housing adjacent to the second housing 1012. Here, in the cuboid module housing 101, the first housing 1011 and the third housing 1013 may be provided as parallel opposite surfaces.

Here, a module housing of a regular shape may be easy to manufacture and easy to lay out due to overall tidiness thereof.

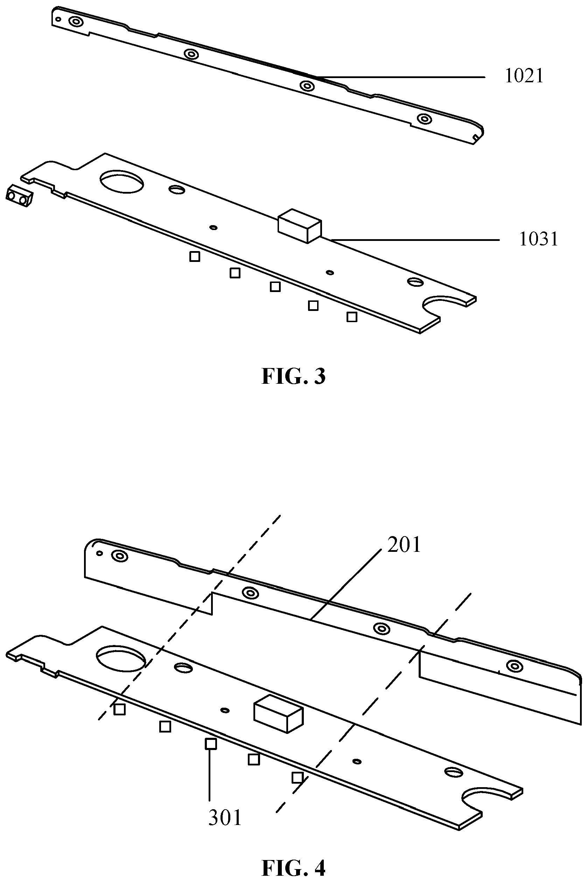

FIG. 3 is a diagram of structures of a first circuit board and a second circuit board in an integrated module according to an exemplary embodiment. As shown in FIG. 3, the audio input component may be mounted on a first circuit board 1021 and face a second housing of the module housing. The second housing may be adjacent to the first housing. The integrated component may be mounted on a second circuit board 1031 and face a third housing of the module housing. The third housing may be another housing adjacent to the second housing.

Note that the first circuit board and the second circuit board may have to be fixed inside the module housing to avoid impact caused by displacement, and ensure normal optical paths of various optical devices. Modes in which the first circuit board and the second circuit board are fixed are introduced below separately.

Here, there may be a sound hole on the second housing. The audio input component may be provided facing the second housing of the module housing having the sound hole, which helps collecting a clearer audio signal. By providing the audio input component on the first circuit board, effective unified control over the large number of pickups included in the audio input component may be implemented.

Note that the audio input component may face a housing with a sound hole, which may be any housing in the module housing. Moreover, for a clear audio signal, the housing with the sound hole may have to face a user. That is, the second housing may be a housing with a sound hole and facing the user.

The first circuit board may be adhered to the second housing with the sound hole. A pickup included in the audio input component mounted on the first circuit board may be provided to be aligned with the sound hole. Thus, by being directly adhered to the housing, the first circuit board occupies less layout space. Moreover, the sound hole and the pickup are in direct contact, facilitating audio signal collection.

Likewise, mounting the integrated component on the second circuit board ensures simultaneous electrical connection of a plurality of functional devices during operation, as well as reducing space occupied corresponding to layout on different circuit boards.

Here, since the integrated component may include many functional devices, the volume of the second circuit board may be large. In this case, if the second circuit board is also provided on the side housing such as the second housing, there will be an increased height of the module housing, which is bad for layout.

To save layout space, the second circuit board may be parallel to the third housing, and include a first outer surface facing the third housing. The first outer surface may be provided with at least one mounting location.

Here, the second circuit board may have a board-shape structure, and include two surfaces provided oppositely, namely, a first outer surface, and a second outer surface facing the first housing and opposite to the first outer surface. When the first outer surface faces the third housing, the second outer surface may face the first housing.

Thus, a board surface on the second circuit board provided with many functional devices may be provided parallel to the third housing. Accordingly, the overall height of the module housing will not increase significantly.

By the second circuit board being parallel to the third housing, the second circuit board may be parallel to, but not closely fit to, the third housing, i.e., there may be a gap between the second circuit board and the third housing. Alternatively, the second circuit board may be parallel to and closely fit the third housing, i.e., the second circuit board and the third housing may be connected to each other tightly with no gap in between. For example, the second circuit board may be adhered to the third housing, with no space gap in between.

Here, when the second circuit board is parallel to, but not closely fit to, the third housing, a mounting location may be provided on the surface of the second circuit board facing the third housing. In this way, some functional devices may be provided at mounting locations on the surface of the second circuit board facing the third housing, avoiding a bulk second circuit board caused by providing all functional devices in the integrated component on one side of the second circuit board.

The second circuit board may be secured to the third housing by screw. That is, the second circuit board may be secured to the third housing by screw connecting the second circuit board to the third housing. The screw mode may allow some space between the second circuit board and the third housing. Accordingly, a mounting location may be provided on the surface of the second circuit board facing the third housing of the module housing.

The second circuit board may be connected to a fourth housing and a fifth housing by screw. Accordingly, one end of the second circuit board may be secured to the fourth housing, and the other end of the second circuit board may be secured to the fifth housing. The fourth housing may be a housing adjacent to both the first housing and the third housing. The fifth housing may be a housing adjacent to both the second housing and the third housing. The fourth housing and the fifth housing may be provided parallel and opposite to each other. In this way, it may be ensured, through the height set by the screw connected to the fourth housing and the fifth housing, that a mounting location may be provided on the surface of the second circuit board facing the third housing.

The second housing may be provided with an opening for outputting light.

Here, an opening may be provided on the second housing for transmitting light emitted by a light emitting device to the outside, so as to be visually perceived by a user. Then, to facilitate visual perception by the user, light may have to be emitted facing a user, or sideways to the user. Since the second housing faces the user, light may be transmitted by directly providing an opening on the second housing, ensure clarity of an audio signal collected while allowing the user to visually experience a light signal sent by the electronic equipment.

Note that the second housing may be made of transparent material, such as transparent resin.

When the second housing is made of transparent material, light may show at a light emitting location even if no opening is provided on the second housing.

Further, since a light emitting device is located on the second circuit board, and the first circuit board is located on the second housing, light emitted by the light emitting device may be blocked, thereby failing to be transmitted outside the second housing. Then, at least one notch may be provided on the first circuit board. The notch may face the opening.

In this way, light emitted by a light emitting device on the second circuit board may be transmitted to a notch on the first circuit board, then transmitted to the opening on the second housing, thereby to the outside, implementing light transmission without occupying too much other space.

Here, a notch may be provided on the first circuit board at a location facing a light emitting surface of a light emitting device, thereby reducing waste of light caused by the fact that not as much light as possible can be transmitted to the outside due to deflection of an optical path.

A notch on the first circuit board may be located at either end of the first circuit board, or in the middle of the first circuit board.

Here, when breathing lights are evenly distributed in a continuous area on the second circuit, a notch may be provided on the first circuit board in the middle, facing light emitting surfaces of light emitting devices. In this way, light may be output corresponding to layout of the breathing lights, reducing loss.

When two blocks of breathing lights are distributed respectively on both ends of the second circuit board, two notches may be provided on the first circuit board respectively at two ends, to conduct light emitted by breathing lights at corresponding locations. Here, breathing lights are divided into two blocks distributed respectively on two ends of the second circuit board, reducing difficulty caused by laying out a large number of breathing lights, facilitating layout of another functional device. Meanwhile, notches may be provided at both ends of the first circuit board, reducing a height of the first circuit board, reducing a volume of the integrated module, saving cost.

The multiple functional devices may include a breathing light. There may be a light guide device between the breathing light and the notch.

Here, such a breathing light may refer to a light which is controlled to turn from light to dark, presenting a breathing effect. A breathing light may be one of a single color or multiple colors. A single-color breathing light may present monochromatic light (light of one color). A multicolored breathing light may present polychromatic or multicolored light. That is, a light emitting device herein may be a breathing light.

The light guide device may serve to conduct light emitted by a breathing light. The light guide device may include a light guide column or a light guide sheet. A light guide device is provided between a breathing light and a notch, reducing light divergence, facilitating light conduction. To save layout, the light guide device may be selected as a light guide sheet.

Note that the light guide device may have to be secured inside the module housing, to reduce optical path disorder and damage caused by displacement. The light guide device may be secured to the second circuit board, to reduce a distance between the light guide device and a breathing light, facilitating light conduction. For example, the light guide device may be secured to the second circuit board by a locating column, i.e., onto the surface of the second circuit board facing the second housing.

To prevent local light leakage, a device made of light-shielding material may be adhered to the light guide device. For example, a light-shielding glue may be adhered to both ends of the light guide device.

FIG. 4 is a diagram of structures of a first circuit board and a second circuit board in an integrated module according to an exemplary embodiment. As shown in FIG. 4, a length of the notch 201 on the first circuit board may be the same as a length of multiple breathing lights 301 lined up on the second circuit board.

Here, a plurality of breathing lights 301 lined up on the second circuit board may emit a strip of light, i.e., forming a light strip. The length of the light strip may be determined by the number and layout of the breathing lights.

When being provided on the second circuit board in a line, the line of breathing lights may be spaced evenly. In this way, when the breathing lights are of multiple colors, various colors in the presented light strip may be distributed evenly, improving a visual effect.

Light emitted by the breathing lights may have to be transmitted to the outside so as to be perceived by a user. Light may be transmitted to the second housing through a notch on the first circuit board, thereby to the outside. Then, the length of the notch on the first circuit board may control a length of a light strip displayed to the outside. In this way, the length of the notch on the first circuit board may be set to be the same as the length of multiple breathing lights lined up on the second circuit board, wasting no material for too long a notch on the first circuit board, while ensuring that the light strip formed by the breathing lights is fully perceived by the user.

The breathing light may be located at the at least one mounting location, with a light-emitting surface facing the second housing.

Here, the at least one mounting location on the second circuit board may be located on a surface of the second circuit board facing the third housing.

For example, the integrated module may be mounted at the lower end of the electronic equipment. Then, a mounting location may be at a lower end of the integrated module. Thus, a breathing light mounted on the mounting location may show, through the opening on the second housing and the corresponding notch on the first circuit board, a light strip at the lower end of the second housing of the module housing of the integrated module facing the user. In this way, light interference to a functional device requiring light, as caused by a light strip located in the middle or at the upper end of the integrated module, may be reduced, improving visual experience.

Here, a mounting location may provide an electrical connection for a breathing light. As the mounting location faces the third housing, a light emitting surface of a breathing light provided directly on the mounting location may face the third housing instead of the second housing. As a result, emitted light cannot reach the outside through the opening on the second housing and the corresponding notch on the first circuit board. A light emitting surface of a breathing light may have to be made to face the second housing.

A light emitting surface of a breathing light may be made to face the second housing by changing a direction along which the light emitting surface is installed on a mounting location, or changing an orientation of a lead when being welded, which is not limited herein.

In this way, by having a light emitting surface of a breathing light face the second housing, as much light emitted by the breathing light as possible may reach the outside through the opening on the second housing and the corresponding notch on the first circuit board, reducing loss.

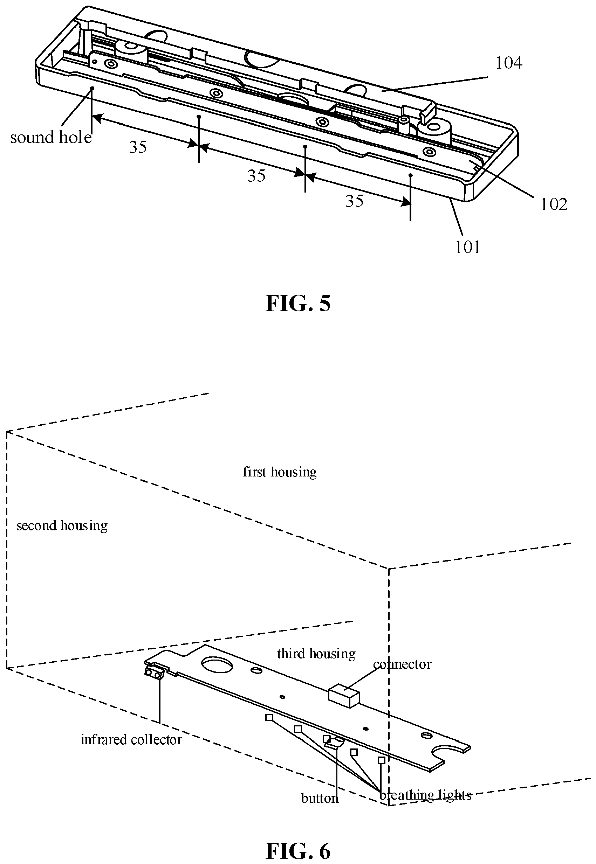

FIG. 5 is an unfolded view of a structure of an integrated module according to an exemplary embodiment. As shown in FIG. 5, a light-shielding plate 104 may be provided on an inner side of the first housing. The light-shielding plate 104 may cover a surface of the first circuit board facing the first housing. An area of the light-shielding plate may be no less than an area of the surface of the first circuit board facing the first housing.

Here, FIG. 5 is an exploded view of the integrated module. For ease of display, the first circuit board may be separated from the second housing. In fact, the first circuit board may be adhered to the second housing having a sound hole. The location of the sound hole on the second housing in FIG. 5 may have to correspond to the location of the pickup on the first circuit board. As shown in FIG. 5, when pickups are lined up on the first circuit board at spacing of 35 mm, sound holes may as well be lined up on the second housing at the spacing of 35 mm.

The first circuit board may include a side surface. The side surface may be perpendicular to a surface adhesively connected to the second housing, and faces the first housing.

Here, the surface adhesively connected to the second housing may refer to a board surface of the first circuit board. The board surface of the first circuit board may be adhesively connected to the second housing, and provided with an audio input component.

The light-shielding plate 104 may cover the side surface of the first circuit board. That is, as shown in FIG. 5, the light-shielding plate 104 may cover the first circuit board from above, and be located inside the first housing, serving to further secure the first circuit board, preventing movement of the first circuit board caused by improper adhesion or deterioration of adhesiveness over time.

Further, an area of the light-shielding plate 104 may be set to be equal to or greater than an area of the side surface. In this way, part of the light-shielding plate 104 may cover the side surface of the first circuit board from above. The other part of the light-shielding plate may cover a location between the first circuit board and the second circuit board. In this case, light may be shielded partly, reducing leakage caused by light being emitted from above.

Here, to better shield light, the light-shielding plate may be made of light-shielding material.

The functional devices may include an infrared collector.

A collecting surface of the infrared collector may face the second housing. The second housing may be made of material that allows infrared light to pass through.

Here, the infrared collector may serve to collect an infrared signal and convert it into an electrical signal. After the infrared signal is transmitted to the main chip, the electronic equipment may be controlled based on the received infrared signal. Here, the collecting surface of the infrared collector may refer to a receiving head of the infrared collector.

For example, the electronic equipment may be a TV. Then, the infrared collector may collect infrared light emitted by a remote control. Accordingly, a channel as well as a working state of the TV may be changed.

As mentioned above, when the second housing faces the user, infrared light may be collected more quickly by providing the collecting surface of the infrared collector to face the second housing. The second housing may be made of material that allows infrared light to pass through, ensuring as much infrared light s possible to pass through the second housing and enter the module housing, so as to be collected by the infrared collector.

Here, the collecting surface of the infrared collector may be made to face the second housing as follows. The infrared collector may be mounted directly on a surface of the second circuit board facing the second housing. In this case, the collecting surface (i.e., the receiving head) of the infrared collector may directly face the second housing. The infrared collector may be provided on the surface of the second circuit board facing the first housing by being sunk into the board or through a special welding process. The collecting surface (i.e., the receiving head) of the infrared collector may be perpendicular to the first housing and face the second housing.

An infrared signal may be collected by providing an opening at a location of the second housing the collecting surface of the infrared collector faces. In this case, material of the second housing is no longer limited hereto.

In addition, since the first circuit board is provided on the second housing, when a collecting surface of the infrared collector faces the second housing, if the collecting surface of the infrared collector faces the mounting location where the first circuit board is mounted, the first circuit board may block infrared light. In view of this, an infrared collector may be provided at either end of a surface of the second circuit board facing the second housing. That is, the length of the second circuit board may be provided to be greater than the length of the first circuit board. Accordingly, in a front view of the second housing, the surface of the second circuit board facing the second housing may extend beyond the first circuit board at both ends. Infrared collectors may be provided at locations on the surface of the second circuit board facing the second housing that extend beyond the first circuit board, i.e., at both ends of the surface of the second circuit board facing the second housing, thereby ensuring that as much infrared light as possible is collected by the infrared collectors.

The functional devices may include a connector.

The connector may be located on the second outer surface of the second circuit board. The connector may be connected to the transmission line passing through the transmission hole. The connector may be configured to provide an electric connection for the second circuit board. The second outer surface may be opposite to the first outer surface.

Here, the connector may refer to an electrical appliance connector for electrically connecting two active devices through a cable. The connector may be a Universal Serial Bus (USB) interface, a serial communication interface, or a parallel communication interface (such as an 8-pin connector).

The first circuit board and the second circuit board may be respectively connected electrically to the motherboard using respective connectors. That is, the first circuit board and the second circuit board may be provided with a connector respectively. Although costing more, using separate connectors may help information transmission, and provide prompt response, allowing multiple circuit boards to work at the same time.

There may be any type and any number of connectors of circuit boards, which are not limited herein.

A connector may be provided on a surface of the second circuit board facing the first housing, which facilitates wiring and reduces the length of a transmission line. That is, the connector does not have to be bent and may be directly connected to the transmission line passing through the transmission hole on the first housing, and then to the motherboard of the electronic equipment through the other end of the transmission line, to establish an electrical connection.

The functional devices may include a button.

The button may be located on the second circuit board. A control surface of the button may face the third housing.

Here, the control surface of the button may refer to a touch surface, i.e., the surface where the button is triggered.

A button herein may be a mechanical button or a capacitive button. When a mechanical button is pressed, a change in the structure of the button may cause a change in the state of a circuit, thereby changing an output electrical signal. Touch of a capacitive button may cause a change in capacitance, which may be detected by the circuit. The circuit may then send, to the motherboard, key value data corresponding to the change in capacitance.

Here, the mechanical structure of a mechanical button may change. Accordingly, when touch is required, the control surface of the button may be made to face the third housing, and then an opening may be provided on the third housing, allowing a user to trigger the button through the opening on the third housing.

A control surface of a capacitive button may be made to face, and stay seamlessly against, the third housing, allowing a user to trigger, by touching the third housing, the capacitive button that is against the third housing. Here, when a capacitive button is selected, no opening has to be provided on the third housing. In this way, the button may be integrated in the integrated module as well, further reducing occupation of layout on the electronic equipment.

FIG. 6 is a diagram of locations of an infrared collector, breathing lights, a button, and a connector located on a second circuit board in an integrated module according to an exemplary embodiment. As shown in FIG. 6, the infrared collector may be located at both ends on the surface of the second circuit board facing the second housing, allowing a collecting surface of the infrared collector to face the second housing directly. Accordingly, infrared light passing through the second housing may be collected faster. The breathing lights may be lined up on mounting locations of the second circuit board facing the third housing.

Light-emitting surfaces of the breathing lights may face the second housing, specifically the opening of the second housing as well as the notch on the first circuit board on the second housing. In FIG. 6, the button, too, may be provided on the surface of the second circuit board facing the third housing. The connector may be provided on the surface of the second circuit board facing the first housing.

In this way, various functional devices may be distributed on several sides of the second circuit board, reducing the volume of the second circuit board, thereby reducing the volume of the entire integrated module, facilitating installation and layout.

With embodiments herein, an audio input component and an integrated component including multiple functional devices of different types are provided in a same module housing, forming an integrated module. In this way, by integrating, in one module housing, respective functional devices that would have been scattered here and there, space occupied by layout of the functional devices may be reduced. In addition, integrating respective functional devices in one module housing facilitates subsequent maintenance. That is, when a functional device in the integrated module fails, only the integrated module has to be detached and maintained separately, instead of moving the entire device for maintenance, which also facilitates maintenance, as well as saving time spent by maintenance personnel looking for a mounting location of a functional device in different products or for different models.

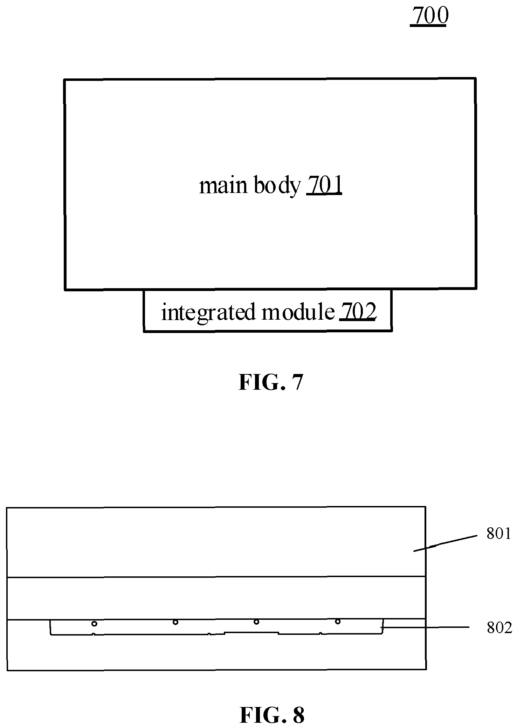

To save space occupied by various functional devices on a smart product, embodiments herein provide display equipment. FIG. 7 is a diagram of a structure of display equipment according to an exemplary embodiment. As shown in FIG. 7, the display equipment 700 may include a main body and an integrated module herein.

The main body 701 may include a display.

The integrated module 702 may be detachably connected to the main body 701.

Note that display equipment herein may be large-screen display equipment, such as a large-screen computer, large-screen teaching equipment, a TV, etc.

Here, FIG. 7 is a diagram of mounting the integrated module 702 below the main body 701 of the display equipment. As mentioned above, alternatively, the integrated module 702 may be mounted on the left side of the main body 701, on the right side of the main body, above the main body, etc.

Here, to facilitate wiring, the integrated module may be mounted according to a location of a surface on the main body of the display equipment having a through hole. That is, when there is a through hole in a bottom surface of the main body of the display equipment, the integrated module may be mounted below the main body of the display equipment. When there is a through hole in a left end surface of the main body of the display equipment, the integrated module may be mounted on the left side of the main body of the display equipment, so on and so forth.

In this way, various functional devices and components on display equipment are transferred from a main body of the display equipment to a same integrated module, effectively reducing space occupied by a plurality of scattered functional components, improving visual experience, facilitating subsequent maintenance, saving time spent by maintenance personnel looking for a mounting location of a functional device in different products or for different models.

The main body may further include a motherboard. Both the motherboard and the display may be located inside an equipment housing.

The equipment housing may be provided with a through hole. The transmission line of the integrated module may be connected to the motherboard through the through hole.

Therefore, an integrated module is connected to a motherboard through a transmission line. Functional devices in the integrated module may be controlled through a signal sent by the motherboard.

The main body may be the body of display equipment. The main body may include an equipment housing, as well as a motherboard and a display located inside the equipment housing.

For example, the display equipment may be a TV. FIG. 8 is a diagram of a physical entity of a TV according to an exemplary embodiment. As shown in FIG. 8, the TV may include a TV housing.

There may be a through hole in a surface of the TV housing 801.

An integrated module 802 herein may be connected to the TV housing through a screw in the through hole.

Through layout of an integrated module 802 herein, light emitted by a breathing light on the integrated module located below the TV housing may be emitted from the front of the TV A user sitting in front of the TV may visually experience a strip of light, improving user experience greatly.

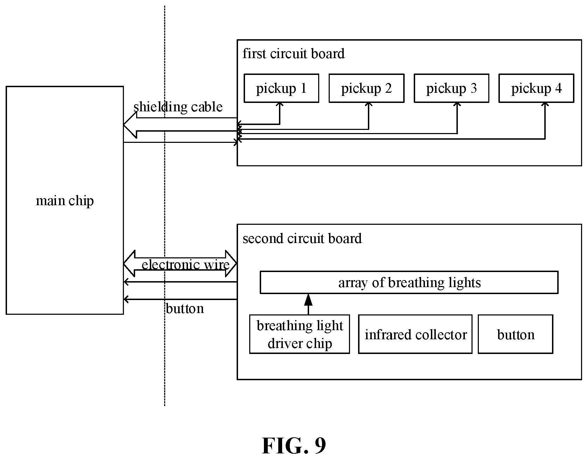

FIG. 9 is a diagram of a control circuit of an integrated module in display equipment according to an exemplary embodiment. As shown in FIG. 9, the display equipment may be a TV, for example. The TV may further include a motherboard.

The motherboard may be located inside a TV housing. The motherboard may be connected to the audio input component in the integrated module through a cable with a shielding function. The cable may pass through the transmission hole of the first housing on the module housing of the integrated module. The motherboard may be connected to the integrated component in the integrated module through an electronic wire passing through the transmission hole.

The motherboard may be configured to provide a control signal to the audio input component as well as a functional device in the integrated component, and to receive data transmitted by the audio input component as well as a functional device in the integrated component.

Here, a main chip may be provided on the motherboard for sending various control instructions, and receiving various data, such as audio data. The motherboard may be connected to the integrated module as follows. The main chip may be connected to the audio input component located on the first circuit board in the integrated module, or to a functional device on the second circuit board in the integrated module.

The electronic wire may be various signal transmission lines, such as an Inter-Integrated Circuit (I2C) Bus.

Here, as shown in FIG. 9, the motherboard may be connected to the second circuit board by an electronic wire. The electronic wire may be applied to most connectors, and may be compact, meeting a requirement of miniaturization of the structure.

Compared to an electronic wire, a connector of a Flexible Flat Cable (FFC) with a shielding function may be smaller in size, meeting a requirement of miniaturization of the structure as well. In addition, a shielding layer of the cable with the shielding function may reduce outward radiation of a clock signal of a microphone or a pickup, facilitating interference test.

In practical application, an audio input component may match different machines or different motherboards. Radiation may differ depending on a machine structure. Therefore, an FFC may be applied to wider scenes thanks to its small volume and shielding function.

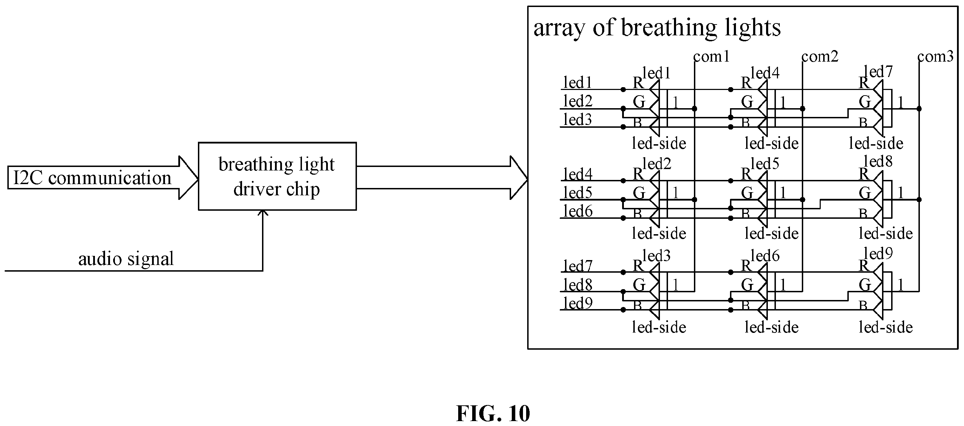

FIG. 10 is a diagram of a control circuit of breathing lights in display equipment according to an exemplary embodiment. As shown in FIG. 10, breathing lights and a breathing light driver chip may be mounted on the second circuit board where the integrated module is located. The breathing light driver chip may output signaling in an array scan mode, and may drive a plurality of breathing lights to emit light at the same time. The number of breathing lights may be provided according to the size of space.

For standardization that suits various types of TVs and facilitates mass production, the breathing lights may be provided to distribute over a same length regardless of the number of the breathing lights. That is, 9 breathing lights may line up on the second circuit board over the same length as 3 breathing lights do. Then, spacing among the 9 breathing lights will be less than spacing among the 3 breathing lights.

The breathing light driver chip shown in FIG. 10 may support I2C communication. An array of breathing lights may be controlled to switch among different lighting effects according to an I2C command sent by the main chip on the motherboard. Here, lighting effects among which the array switches may be preset. The breathing light driver chip may also output, according to a collected audio signal, a lighting effect that varies with sound, enriching scenes of application of breathing lights.

Therefore, herein, an audio input component and an integrated component including multiple functional devices of different types are provided in a same module housing, forming an integrated module. In this way, by integrating, in one module housing, respective functional devices that would have been scattered here and there, space occupied by layout of the functional devices may be reduced. In addition, control is achieved by electrically connecting functional devices in the integrated module to the motherboard of the TV, various functional devices are allowed to be managed in a standardized mode, and the wiring mode and the electrical connection mode may be applied to most types of TVs, facilitating standardized production.

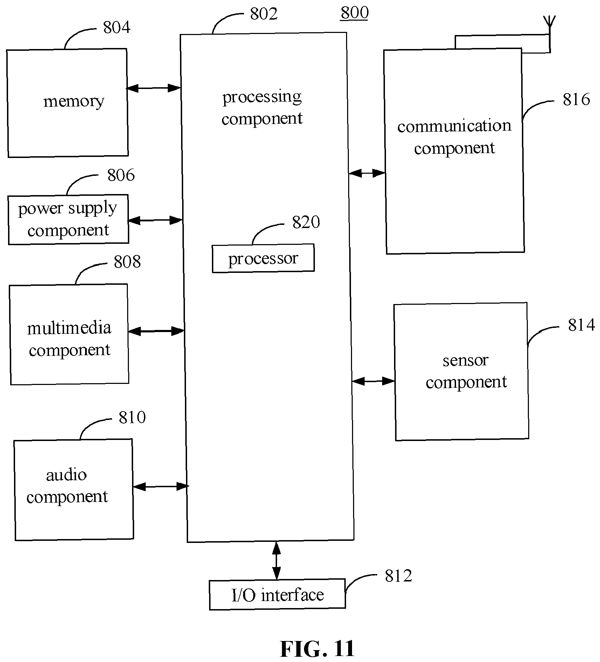

FIG. 11 is a block diagram of electronic equipment 800 including an integrated module 100 according to an exemplary embodiment. For example, the electronic equipment 800 may be UE such as a mobile phone, a computer, digital broadcast UE, messaging equipment, a gaming console, tablet equipment, medical equipment, fitness equipment, a personal digital assistant, etc.

Referring to FIG. 11, the electronic equipment 800 may include at least one of a processing component 802, memory 804, a power supply component 806, a multimedia component 808, an audio component 810, an Input / Output (I / O) interface 812, a sensor component 814, a communication component 816, etc.

The processing component 802 may generally control an overall operation of the electronic equipment 800, such as operations associated with display, a telephone call, data communication, a camera operation, a recording operation, etc. The processing component 802 may include one or more processors 820 to execute instructions so as to complete all or part of an aforementioned method. In addition, the processing component 802 may include one or more modules to facilitate interaction between the processing component 802 and other components. For example, the processing component 802 may include a multimedia portion to facilitate interaction between the multimedia component 808 and the processing component 802.

The memory 804 may be adapted to storing various types of data to support the operation at the electronic equipment 800. Examples of such data may include instructions of any APP or method adapted to operating on the electronic equipment 800, contact data, phonebook data, messages, pictures, videos, etc. The memory 804 may be realized by any type of transitory or non-transitory storage equipment or a combination thereof, such as Static Random Access Memory (SRAM), Electrically Erasable Programmable Read-Only Memory (EEPROM), Erasable Programmable Read-Only Memory (EPROM), Programmable Read-Only Memory (PROM), Read-Only Memory (ROM), magnetic memory, flash memory, a magnetic disk, a compact disk, etc.

The power supply component 806 may supply electric power to various components of the electronic equipment 800. The power supply component 806 may include a power management system, one or more power sources, and other components related to generating, managing, and distributing electricity for the electronic equipment 800.

The multimedia component 808 may include a screen that provides an output interface between the electronic equipment 800 and a user. The screen may include a Liquid Crystal Display (LCD), a Touch Panel (TP), etc. If the screen may include a TP, the screen may be realized as a touch screen to receive a signal input by a user. The TP may include one or more touch sensors for sensing touch, slide, and gestures on the TP. The one or more touch sensors not only may sense the boundary of a touch or slide move, but also detect the duration and pressure related to the touch or slide move.

The multimedia component 808 may include at least one of a front camera or a rear camera. When the electronic equipment 800 is in an operation mode such as a photographing mode or a video mode, at least one of the front camera or the rear camera may receive external multimedia data. Each of the front camera or the rear camera may be a fixed optical lens system or may have a focal length and be capable of optical zooming.

The audio component 810 may be adapted to outputting and / or inputting an audio signal. For example, the audio component 810 may include a microphone (MIC). When the electronic equipment 800 is in an operation mode such as a call mode, a recording mode, a voice recognition mode, etc. , the MIC may be adapted to receiving an external audio signal. The received audio signal may be further stored in the memory 804 or may be sent via the communication component 816. The audio component 810 may further include a loudspeaker adapted to outputting the audio signal.

The I/O interface 812 may provide an interface between the processing component 802 and a peripheral interface portion. Such a peripheral interface portion may be a keypad, a click wheel, a button, etc. Such a button may include but is not limited to at least one of a homepage button, a volume button, a start button, or a lock button.

The sensor component 814 may include one or more sensors for assessing various states of the electronic equipment 800. For example, the sensor component 814 may detect an on/off state of the electronic equipment 800 and relative locationing of components such as the display and the keypad of the electronic equipment 800. The sensor component 814 may further detect a change in the location of the electronic equipment 800 or of a component of the electronic equipment 800, whether there is contact between the electronic equipment 800 and a user, the orientation or acceleration / deceleration of the electronic equipment 800, a change in the temperature of the electronic equipment 800, etc. The sensor component 814 may include a proximity sensor adapted to detecting existence of a nearby object without physical contact. The sensor component 814 may further include an optical sensor such as a Complementary Metal-Oxide-Semiconductor (CMOS) or a Charge-Coupled-Device (CCD) image sensor used in an imaging APP. The sensor component 814 may further include an acceleration sensor a gyroscope sensor a magnetic sensor a pressure sensor a temperature sensor etc.

The communication component 816 may be adapted to facilitating wired or wireless communication between the electronic equipment 800 and other equipment. The electronic equipment 800 may access a wireless network based on a communication standard such as Wi-Fi, 2G, 3G..., or a combination thereof. The communication component 816 may broadcast related information or receive a broadcast signal from an external broadcast management system via a broadcast channel. The communication component 816 may include a Near Field Communication (NFC) module for short-range communication. For example, the NFC module may be based on technology such as Radio Frequency Identification (RFID), Infrared Data Association (IrDA), Ultra-Wideband (UWB) technology, Bluetooth (BT), etc.

The electronic equipment 800 may be realized by one or more electronic components such as an APP Specific Integrated Circuit (ASIC), a Digital Signal Processor (DSP), a Digital Signal Processing Device (DSPD), a Programmable Logic Device (PLD), a Field Programmable Gate Array (FPGA), a controller, a microcontroller, a microprocessor, etc., to implement the method.

A non-transitory computer-readable storage medium including instructions, such as memory 804 including instructions, may be provided. The instructions may be executed by the processor 820 of the electronic equipment 800 to implement the method. For example, the non-transitory computer-readable storage medium may be Read-Only Memory (ROM), Random Access Memory (RAM), Compact Disc Read-Only Memory (CD-ROM), a magnetic tape, a floppy disk, optical data storage equipment, etc.

A non-transitory computer-readable storage medium has stored thereon instructions which, when executed by a processor of a device for identifying a gesture, enable the device to implement a method herein.

Further note that herein by "multiple", it may mean two or more. Other quantifiers may have similar meanings. A term "and / or" may describe an association between associated objects, indicating three possible relationships. For example, by A and / or B, it may mean that there may be three cases, namely, existence of but A, existence of both A and B, or existence of but B. A slash mark "/" may generally denote an "or" relationship between two associated objects that come respectively before and after the slash mark. Singulars "a/an", "said" and "the" are intended to include the plural form, unless expressly illustrated otherwise by context.

Further note that although in drawings herein operations are described in a specific or der, it should not be construed as that the operations have to be performed in the specific or der or sequence, or that any operation shown has to be performed in or der to acquire an expected result. Under a specific circumstance, multitask and parallel processing may be advantageous.

Other embodiments according to the subject disclosure will be apparent to one skilled in the art after he/she has considered the subject disclosure and practiced the invention disclosed herein. The subject disclosure and its embodiments are intended to be exemplary only, with the scope of the invention being defined by the appended claims.

The subject disclosure is not limited to the exact construction that has been described above and illustrated in the accompanying drawings. Various modifications and changes may be made without departing from the scope of the subject disclosure. It is intended that the scope of the invention be limited only by the appended claims.

## Claims

1. An integrated module (100, 702, 802), comprising a module housing (101), an audio input component (102), and an integrated component (103);
the module housing (101), having a transmission hole;
the audio input component (102) being located inside the module housing (101);
the integrated component (103) being located inside the module housing (101), the integrated component (103) comprising multiple functional devices of different types;
the transmission hole being provided for a transmission line that establishes an electrical connection with at least one of the audio input component (102) or the integrated component (103) to pass through.

2. The integrated module (100, 702, 802) of claim 1, wherein the transmission hole is located on a first housing (1011) of the module housing (101);
wherein the audio input component (102) is mounted on a first circuit board (1021) and faces a second housing (1012) of the module housing (101), wherein the second housing (1012) is adjacent to the first housing (1011);
wherein the integrated component (103) is mounted on a second circuit board (1031) and faces a third housing (1013) of the module housing (101), wherein the third housing (1013) is adjacent to the second housing (1012).

3. The integrated module (100, 702, 802) of claim 2, wherein the second housing (1012) is provided with an opening for outputting light,
wherein the first circuit board (1021) is provided with at least one notch (201), wherein the at least one notch (201) faces the opening,
wherein the multiple functional devices comprise a breathing light (301), wherein there is a light guide device between the breathing light (301) and the notch (201).

4. The integrated module (100, 702, 802) of claim 3,
wherein a length of the notch (201) on the first circuit board (1021) is same as a length of a line of a plurality of the breathing light (301) on the second circuit board (1031).

5. The integrated module (100, 702, 802) of claim 3,
wherein the second circuit board (1031) is parallel to the third housing (1013) and comprises a first outer surface facing the third housing (1013), wherein the first outer surface is provided with at least one mounting location,
wherein the breathing light (301) is located at the at least one mounting location, with a light-emitting surface facing the second housing (1012).

6. The integrated module (100, 702, 802) of claim 5,
wherein the second circuit board (1031) further comprises a second outer surface facing the first housing (1011), the second outer surface being opposite to the first outer surface;
wherein the multiple functional devices comprise a connector,
wherein the connector is located on the second outer surface, wherein the connector is connected to the transmission line passing through the transmission hole, wherein the connector is configured to provide an electric connection for the second circuit board (1031).

7. The integrated module (100, 702, 802) of claim 2 or any claim dependent thereon, wherein the multiple functional devices comprise an infrared collector,
wherein a collecting surface of the infrared collector faces the second housing (1012), wherein the second housing (1012) is made of material that allows infrared light to pass through.

8. The integrated module (100, 702, 802) of claim 2 or any claim dependent thereon,
wherein the first circuit board (1021) is adhered to the second housing (1012), wherein the second housing (1012) has a sound hole,
wherein the audio input component (102) comprises a pickup, wherein the pickup is aligned with the sound hole.

9. The integrated module (100, 702, 802) of claim 8,
wherein the first circuit board (1021) comprises a side surface, wherein the side surface is perpendicular to a surface adhesively connected to the second housing (1012), and faces the first housing (1011),
wherein a light-shielding plate (104) is provided on an inner side of the first housing (1011), wherein the light-shielding plate (104) covers the side surface of the first circuit board (1021), wherein an area of the light-shielding plate (104) is no less than an area of the side surface.

10. The integrated module (100, 702, 802) of claims 2 to 6, wherein the multiple functional devices comprise a button,
wherein the button is located on the second circuit board (1031), wherein a control surface of the button faces the third housing (1013).

11. Display equipment, comprising:
a main body (701) comprising a display; and
the integrated module (100, 702, 802) of any one of claims 1 to 10, the integrated module (100, 702, 802) being detachably connected to the main body (701).

12. The display equipment of claim 11, wherein the main body (701) further comprises a motherboard,
wherein both the motherboard and the display are located inside an equipment housing,
wherein the equipment housing is provided with a through hole,
wherein the transmission line of the integrated module (100, 702, 802) is connected to the motherboard through the through hole.
